# EUROPEAN PATENT APPLICATION

(11) **EP 2 787 794 A1**
(43) Date of publication of application: **08.10.2014**
(21) Application number: 12854121.6
(22) Date of filing: 20.11.2012
(51) Int. Cl.: H05B 37/02, F21S 2/00, F21S 9/03, H01L 31/042, H01L 51/50

(54) **LIGHT-EMITTING DEVICE**

(30) Priority: 30.11.2011 JP 2011262450
(71) Applicant: Panasonic Corporation, Osaka 571-8501 (JP)
(72) Inventor: KODAMA, Naofumi, Osaka 540-6207 (JP); SUENAGA, Toshiharu, Osaka 540-6207 (JP); SONODA, Masato, Osaka 540-6207 (JP)
(74) Representative: Müller-Boré & Partner Patentanwälte PartG mbB
(86) International application number: PCT/JP2012/080025
(87) International publication number: WO 2013/080836

(57) **Abstract**

A light-emitting device includes a planar light-emitting unit having a light-emitting surface and a non-light-emitting surface, a planar solar power generator having a light-receiving part and a non-light-receiving part, and a rechargeable battery. The light-emitting unit and the solar power generator are arranged so that the non-light-emitting surface and the non-light-receiving surface face each other, thereby forming a light-electricity converter. The light-emitting device includes an orientation sensor configured to sense an orientation of the light-electricity converter, and a connection switch which is arranged between the non-light-emitting surface of the light-emitting unit and the non-light-receiving surface of the solar power generator, and which is configured to selectively connect the rechargeable battery to either the light-emitting unit or the solar power generator. The connection switch is configured to connect the rechargeable battery: to the solar power generator when the orientation sensor detects that the light-receiving surface of the solar power generator in the light-electricity converter faces toward a first direction; and to the light-emitting unit when the orientation sensor detects that the light-emitting surface of the light-emitting unit in the light-electricity converter faces toward the first direction.

## Description

### TECHNICAL FIELD

The present invention relates to a light-emitting device.

### BACKGROUND ART

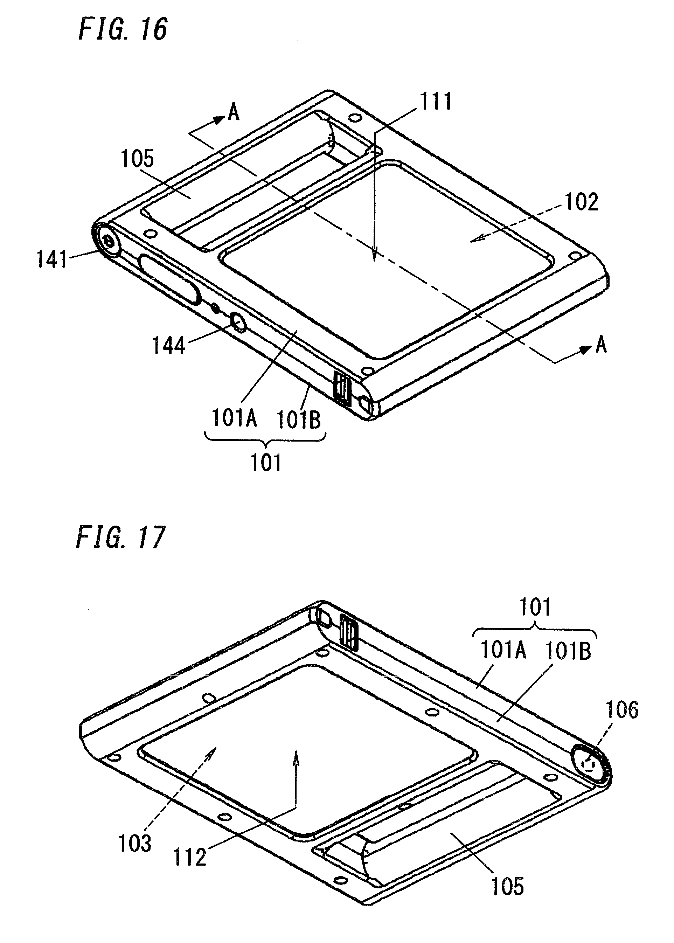

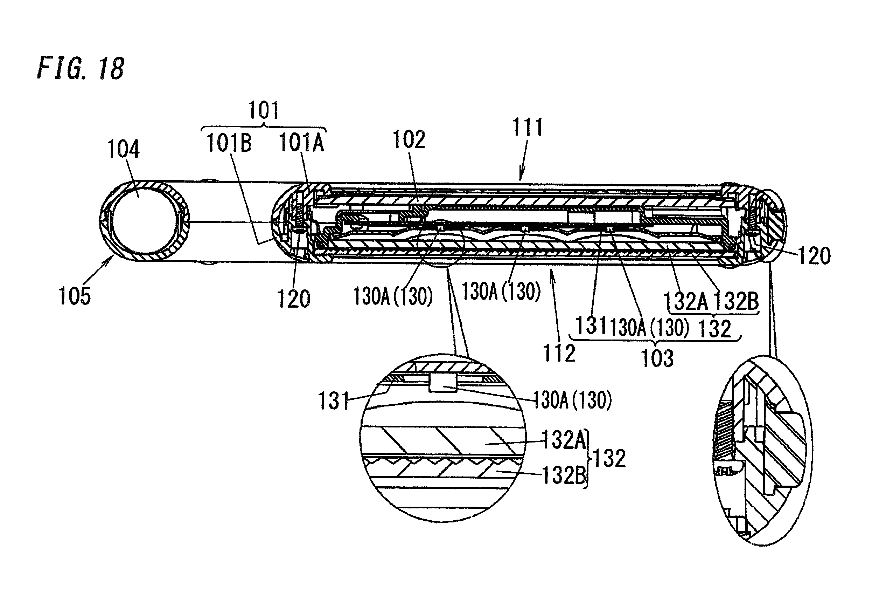

Japanese Patent Application Publication No. 2010-55789 has proposed a portable illumination device of which structure is shown in FIGS. 16 to 18, as an example of a light-emitting device provided with a solar power generator.

This illumination device includes an exterior case **101,** a rechargeable battery **104** housed in the exterior case **101,** a solar cell (a solar power generator) **102** for charging the battery **104,** and a light panel 103 powered by the battery **104.**

In the illumination device, the solar cell **102** and the light panel **103** are arranged on a first surface **111** side and a second surface **112** side of the exterior case **101,** respectively. Thus, in the illumination device, the solar cell **102** and the light panel **103** are arranged to face each other. In the illumination device, the battery **104** is arranged in a periphery of the exterior case **101** at a position lateral to the solar cell **102** and the light panel **103.** The exterior case **101** is composed of a first case **101A** and a second case **101B.** The first case **101A** and the second case **101B** are fixed to each other by screws **120.**

The light panel **103** includes point light sources **130** which are composed of white light emitting diodes **130A,** a reflector **131** configured to reflect lights from the point light sources **130,** and a light diffuser panel **132** provided on a front surface of the reflector **131.** The diffuser panel **132** is a laminate of a first diffuser panel **132A** and a second diffuser panel **132B.**

The point light sources **130** composed of the white light emitting diodes **130A** are arranged between the reflector **131** and the diffuser panel **132** in the light panel **103,** and accordingly the lights of the point light sources **130** can be uniformly diffused and then to be emitted outside.

Besides, the illumination device includes a grip **105,** and a beam light source **106** and a light switch **141** are arranged at one end and the other end of the grip **105,** respectively. The illumination device further includes a control circuit (not shown). The control circuit is connected to the light switch **141** in the form of push-button, the solar cell **102,** an external input connector (not shown), an USB connector (not shown), an USB switch **144,** and the like. The external input connector is configured to be connected to an AC adapter (not shown) to supply the battery **104** with electric power for charging. The illumination device is configured so that when the USB switch **144** is pressed, the control circuit converts the energy stored in the battery **104** into a predetermined voltage to output through the USB connector.

The control circuit is configured to switch lighting states of the light panel **103** and the beam light source **106** in response to an ON signal supplied from the light switch **141** in the form of push-button. The control circuit is configured to switch the lighting states of the light panel **103** and the beam light source **106** in the following order: "turning on the beam light source **106";** "turning off the beam light source **106** and turning on nine of the light emitting diodes **130A** of the light panel **103";** "turning on five of the light emitting diodes **130A** of the light panel **103";** "turning on one of the light emitting diodes **130A** of the light panel **103";** and "turning off the light panel **103",** in response to each depression of the light switch **141,** for example.

The illumination device is configured so that if the light switch **141** is pressed and held down in a state where the beam light source **106** or the light panel **103** is turned on, the beam light source **106** or the light panel **103** being turned on is turned off.

In order to switch the illumination device between a state of turning the light panel **103** on by electric power from the battery **104** and a state of charging the battery **104** through the solar cell **102,** a user is required to operate the light switch **141** in the form of push-button. Therefore, this illumination device is not convenient for users.

Besides, there is a concern about the deterioration of the appearance, since the illumination device needs the light switch **141** which is exposed outward.

### DISCLOSURE OF INVENTION

The invention has been developed in view of the above circumstances, and object thereof is to provide a light-emitting device having an improved convenience and an improved appearance.

A light-emitting device according to the invention includes: a light-emitting unit shaped like a plane having a light-emitting surface and a non-light-emitting surface; a solar power generator shaped like a plane having a light-receiving part and a non-light-receiving part; and a rechargeable battery. The light-emitting unit and the solar power generator are arranged so that the non-light-emitting surface and the non-light-receiving surface face each other, thereby forming a light-electricity converter. The light-emitting device of the invention further includes: an orientation sensor configured to sense an orientation of the light-electricity converter; and a connection switch which is arranged between the non-light-emitting surface of the light-emitting unit and the non-light-receiving surface of the solar power generator, and which is configured to selectively connect the rechargeable battery to either the light-emitting unit or the solar power generator. The light-emitting device is configured so that: the connection switch connects the rechargeable battery to the solar power generator when the orientation sensor detects that the light-receiving surface of the solar power generator in the light-electricity converter faces toward a first direction; and the connection switch connects the rechargeable battery to the light-emitting unit when the orientation sensor detects that the light-emitting surface of the light-emitting unit in the light-electricity converter faces toward the first direction.

In the light-emitting device, it is preferred that the connection switch is formed of a tilt switch that doubles as the orientation sensor.

In the light-emitting device, it is preferred that the rechargeable battery is arranged between the light-emitting unit and the solar power generator.

In the light-emitting device, it is preferred that the light-emitting unit includes an organic electroluminescent panel.

The light-emitting device of the invention has an improved convenience and an improved appearance.

### BRIEF DESCRIPTION OF DRAWINGS

FIG. 1 is a schematic sectional view of a light-emitting device according to a first embodiment;
FIG. 2 is a schematic perspective view of the light-emitting device according to the first embodiment as seen from a light-emitting unit side;
FIG. 3 is a schematic perspective view of the light-emitting device according to the first embodiment as seen from a solar power generator side;
FIG. 4 is a schematic exploded perspective view of the light-emitting device according to the first embodiment;
FIG. 5 is a schematic planar view of an organic electroluminescent panel in the light-emitting device according to the first embodiment;
FIG. 6 is an explanatory diagram of an operation of the light-emitting device according to the first embodiment;
FIG. 7 is a schematic sectional view of a light-emitting device according to a second embodiment;
FIG. 8 is a schematic perspective view of the light-emitting device according to the second embodiment as seen from a light-emitting unit side;
FIG. 9 is a schematic exploded perspective view of the light-emitting device according to the second embodiment;
FIG. 10 is a side view of a main part of the light-emitting device according to the second embodiment;
FIG. 11 is an explanatory diagram of an operation of the light-emitting device according to the second embodiment;
FIG. 12 is a schematic sectional view of a light-emitting device according to a third embodiment;
FIG. 13 is an explanatory diagram of an operation of the light-emitting device according to the third embodiment;
FIG. 14 is a schematic sectional view of a light-emitting device according to a fourth embodiment;
FIG. 15 is an explanatory diagram of an operation of the light-emitting device according to the fourth embodiment;
FIG. 16 is a perspective view of a conventional portable illumination device;
FIG. 17 is a perspective view, as seen from a rear side, of the portable illumination device shown in FIG. 16; and
FIG. 18 is a sectional view of the portable illumination device taken along a line A-A of FIG. 16.

### DESCRIPTION OF EMBODIMENTS

### (First Embodiment)

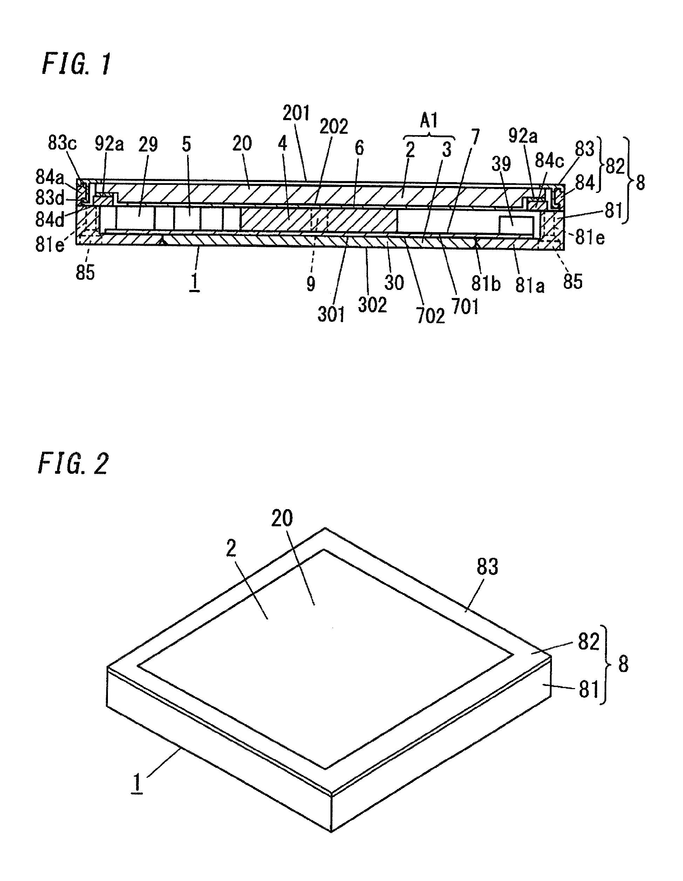

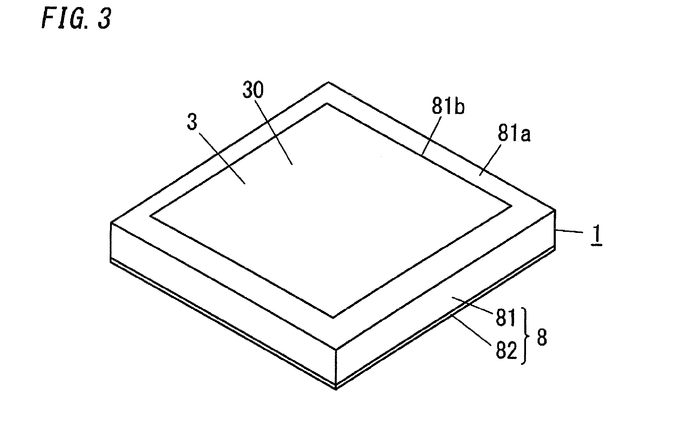

A light-emitting device according to the embodiment is described with reference to FIGS. 1 to 6.

The light-emitting device **1** of the embodiment includes a light-electricity converter **A1,** a rechargeable battery **4,** an orientation sensor **51,** and a connection switch 52. The light-electricity converter **A1** is constituted by a light-emitting unit **2** shaped like a plane and a solar power generator 3 shaped like a plane. The light-emitting unit **2** and the solar power generator **3** are arranged so that rear surfaces of them face each other. The orientation sensor **51** is configured to sense an orientation of the light-electricity converter **A1**. The connection switch **52** is arranged between the light-emitting unit **2** and the solar power generator **3,** and is configured to selectively connect the rechargeable battery **4** to either the light-emitting unit **2** or the solar power generator **3.** The light-emitting device **1** is configured so that: the connection switch **52** connects the rechargeable battery **4** to the solar power generator **3** when the orientation sensor **51** detects an orientation of the light-electricity converter **A1** that the solar power generator **3** side is upside; and the connection switch **52** connects the rechargeable battery **4** to the light-emitting unit **2** when the orientation sensor **51** detects an orientation of the light-electricity converter **A1** that the light-emitting unit **2** side is upside.

The light-emitting device **1** includes the rechargeable battery **4,** and the light-electricity converter **A1** constituted by the light-emitting unit **2** shaped like a plane and the solar power generator 3 shaped like a plane. In the light-electricity converter **A1,** the light-emitting unit **2** and the solar power generator **3** are arranged so that rear surfaces of the light-emitting unit **2** and the solar power generator **3** face (are opposite to) each other. In other words, the light-emitting unit **2** has a light-emitting surface **201** and a non-light-emitting surface **202,** and the solar power generator **3** has a non-light-receiving surface **301** and a light-receiving surface **302.** The light-emitting unit **2** and the solar power generator **3** are arranged so that the non-light-emitting surface **202** and the non-light-receiving surface **301** face each other.

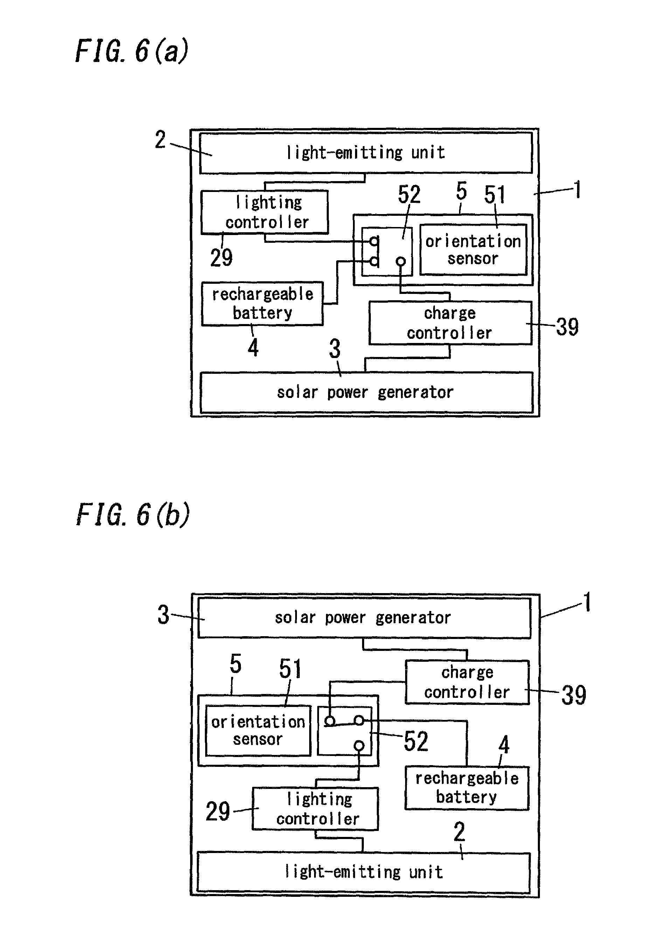

The light-emitting device 1 further includes a tilt switch **5.** The tilt switch **5** is arranged between the non-light-emitting surface **202** of the light-emitting unit **2** and the non-light-receiving surface **301** of the solar power generator **3.** In the light-emitting device **1** of the embodiment, the tilt switch **5** includes (functions as): the orientation sensor **51** (see FIG. 6) configured to sense an orientation of the light-electricity converter **A1;** and the connection switch **52** (see FIG. 6) which is arranged between the light-emitting unit **2** and the solar power generator **3** and which is configured to selectively connect the rechargeable battery **4** to either the light-emitting unit **2** or the solar power generator **3.** The connection switch **52** is formed of a contact device of a change-over contact type, but is not limited thereto.

The orientation sensor **51** is configured to detect an orientation of the light-emitting device **1** based on a first direction, where the first direction is a direction extending perpendicularly from a placed surface on which the light-emitting device **1** is put. In a case where the light-receiving surface **302** of the solar power generator **3** is laid on the placed surface, the orientation sensor **51** decides that the light-emitting surface **201** of the light-emitting unit **2** of the light-emitting device **1** is positioned in the first direction side (i.e., positioned upside) relative to the light-receiving surface **302.** On the other hand, in a case where the light-emitting surface **201** of the light-emitting unit **2** is laid on the placed surface, the orientation sensor **51** decides that the light-receiving surface **302** of the solar power generator **3** of the light-emitting device 1 is positioned in the first direction side (i.e., positioned upside) relative to the light-emitting surface **302.**

The light-emitting device 1 is configured so that: the connection switch **52** connects the rechargeable battery **4** to the solar power generator **3** (see FIG. 6(b)) when the orientation sensor **51** detects that the side of the light-receiving surface **302** of the solar power generator **3** in the light-electricity converter **A1** is upside; and the connection switch **52** connects the rechargeable battery **4** to the light-emitting unit **2** (see FIG. 6(a)) when the orientation sensor **51** detects that the side of the light-emitting surface **201** of the light-emitting unit **2** in the light-electricity converter **A1** is upside. The light-emitting device **1** is configured so that: when the rechargeable battery **4** is connected to the solar power generator **3,** the rechargeable battery **4** is charged by the solar power generator **3;** and when the rechargeable battery **4** is connected to the light-emitting unit **2,** the light-emitting unit **2** is supplied with electric power from the rechargeable battery **4** to emit light. In short, the light-emitting device **1** includes the tilt switch **5** which is configured to sense an orientation of the light-electricity converter **A1** and to selectively switch between a charging path from the solar power generator **3** to the rechargeable battery **4** and a feeding path from the rechargeable battery **4** to the light-emitting unit **2.**

In the light-emitting device **1,** the rechargeable battery **4** is preferably arranged between the light-emitting unit **2** and the solar power generator **3.** With this configuration, the light-emitting unit **2** and the solar power generator **3** can have larger occupied dimensions in comparison with a case where the rechargeable battery **4** is arranged lateral to the light-electricity converter **A1,** and thus the light-emitting device **1** can be improved cosmetically.

The light-emitting unit **2** is shaped like a rectangle in planar view. However, the shape of the light-emitting unit **2** is not limited thereto. The light-emitting unit **2** can be shaped like a planar plate having a desired shape. The light-emitting unit **2** is formed of an organic electroluminescent panel (hereinafter called an "organic EL panel") **20.**

The solar power generator **3** is shaped like a rectangle in planar view. However, the shape of the solar power generator **3** is not limited thereto. The solar power generator **3** can be shaped like a planar plate having a desired shape. The solar power generator **3** is formed of a solar panel **30.**

The light-emitting device **1** includes: a lighting controller **29** which is arranged between the light-emitting surface **201** of the light-emitting unit **2** and the light-receiving surface **302** of the solar power generator **3,** and which is configured to control a light output of the light-emitting unit **2;** and a charge controller **39** which is arranged between the light-emitting unit **2** and the solar power generator **3,** and which is configured to charge the rechargeable battery **4** with energy generated by the solar power generator **3.** In other words, the light-emitting device **1** includes the lighting controller **29** and the charge controller **39,** and both of the lighting controller **29** and the charge controller **39** are arranged between the light-emitting unit **2** and the solar power generator **3.** The lighting controller **29** is configured to control the light output of the light-emitting unit **2.** The charge controller **39** is configured to charge the rechargeable battery **4** with the electric power generated by the solar power generator **3.**

The light-emitting device **1** includes an exterior case **8** in which the light-emitting unit **2,** the solar power generator **3,** the rechargeable battery **4,** the tilt switch **5,** the lighting controller **29,** the charge controller **39,** a circuit board **7** and the like are housed.

Components of the light-emitting device 1 will be described in detail below.

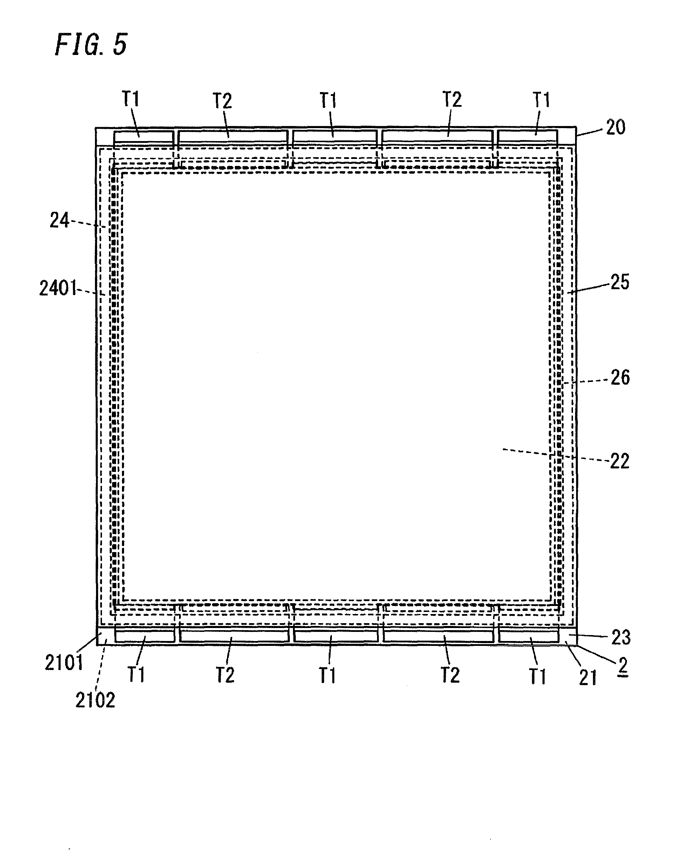

The organic EL panel 20 that forms the light-emitting unit 2 may have a configuration shown in FIG. 5. The organic EL panel 20 includes: a device substrate 23 having an organic electroluminescent device (hereinafter, called an "organic EL device") 22 provided on one surface side of a substrate 21 (a first surface 2101 side of the substrate **21**); and a sealing member (a cover substrate) 25 bonded to the device substrate 23 at the first surface 2101 side of the substrate 21 via a frame-shaped joint member 24. The joint member 24 is arranged so that a first surface 2401 of the joint member 24 faces the first surface 2101 of the substrate 21. The organic EL device 22 includes: a first electrode provided at the first surface 2101 side of the substrate 21; a second electrode provided at the first surface 2101 side of the substrate 21 so as to face the first electrode; and a functional layer which is laid between the first electrode and the second electrode and which includes at least a light-emitting layer. Each of the first electrode and the second electrode is shaped like a plane. The functional layer, which includes at least the light-emitting layer, is arranged between the first electrode and the second electrode in a thickness direction of the organic EL device **22.**

The other surface of the substrate **21** (a second surface **2102** of the substrate **21)** serves as a light output surface (a light-emitting surface) of the organic EL panel **20.** The substrate **21** is formed of a glass substrate in the embodiment. Examples of the glass substrate include a soda-lime glass substrate and an alkali-free glass substrate.

The substrate **21** is not limited to the glass substrate, and a plastic substrate may be used. Examples of the plastic substrate include a polyethylene terephthalate (PET) substrate, a polyethylene naphthalate (PEN) substrate, a polyethersulfone (PES) substrate and a polycarbonate (PC) substrate. In case of using the plastic substrate, it is preferred to form an SiON film, SiN film or the like on a surface of the plastic substrate to reduce moisture permeability.

The first electrode is preferably formed of transparent conducting oxide (TCO). Examples of the transparent conducting oxide include ITO, AZO, GZO and IZO. The second electrode is preferably formed of metal.

In the organic EL device **22,** the first electrode is formed as an anode and the second electrode is formed as a cathode, but the cathode may be the first electrode and the anode may be the second electrode. The functional layer is not limited other than including the light-emitting layer, and the functional layer may further include at least one selected from a group consisting of a hole-injection layer, a hole-transport layer, an electron-transport layer, an electron-injection layer and the like. Layer structure of the functional layer is not particularly limited.

The organic EL panel **20** includes: first terminals **T1** electrically connected to the first electrode of the organic EL device **22;** and second terminals **T2** electrically connected to the second electrode of the organic EL device **22.** Each of the first terminals **T1** and the second terminals **T2** is arranged lateral to the organic EL device **22** at the first surface **2101** side of the substrate **21.**

It is preferred that the organic EL device **22** includes an auxiliary electrode **26** which is formed of material having smaller resistibility than that of the first electrode and which is electrically connected to the first electrode. The auxiliary electrode **26** may be formed along a circumstance of a surface of the first electrode, which is a surface opposite of the substrate **21** from the first electrode. In other words, the auxiliary electrode **26** may be formed along the circumstance of a first surface of the first electrode facing the first surface **2101** of the substrate **21.**

In the organic EL panel **20,** m-pieces ("m" = "two" in an example of FIG. 5) of second terminals **T2** and [m+1] pieces (three pieces in the example of FIG. 5) of first terminals **T1** are arranged on each of predetermined two sides, which are parallel with each other, of the rectangular-shaped organic EL device **22.** A first terminal **T1** is arranged on each side of a second terminal **T2** in a width direction with leaving a predetermined space therebetween, so that the second terminal **T2** is apart from the first terminal **T1.** The above-mentioned "m" indicates an integer number. Thus, in the example of FIG. 5, the first terminals **T1** and the second terminals **T2** are provided on each end in a longitudinal direction of the substrate **21.** In detail, in each end in the longitudinal direction of the substrate **21** of the organic EL panel **20,** the three first terminals **T1** are positioned at intervals along a width direction of the substrate **21** and each of the second terminals **T2** is arranged between first terminals **T1** neighboring in the width direction of the substrate **21.** In the embodiment, the longitudinal direction of the substrate **21** in the first surface **2101** is defined as a prescribed direction. The device substrate **23** is provided with the first terminals **T1** and the second terminals **T2** which are arranged on each end in the prescribed direction of the substrate **21** on the first surface **2101.**

Each of the first terminals **T1** and the second terminals **T2** has a layered structure of a transparent conducting oxide layer and a metal layer.

Material of the metal layer is preferably selected from: metal such as aluminum, silver, gold, copper, chrome, molybdenum, aluminum, palladium, tin, lead, and magnesium; and alloy which includes at least one of the recited metals. The metal layer is not limited to have a single-layer structure, and may have a multi-layer structure. The metal layer may have a three-layer structure composed of an MoNb layer, an AlNd layer, and an MoNb layer. In this three-layer structure, the lower MoNb layer is provided as an adhesion layer with respect to a foundation, and the upper MoNb layer is provided as a protection layer for protecting the AlNd layer.

Material of the auxiliary electrode **26** is preferably selected from: metal such as aluminum, silver, gold, copper, chrome, molybdenum, aluminum, palladium, tin, lead, and magnesium; and alloy which includes at least one of the recited metals. The auxiliary electrode **26** is not limited to have a single-layer structure, and may have a multi-layer structure. The auxiliary electrode **26** may have a three-layer structure composed of an MoNb layer, an AlNd layer, and an MoNb layer. In this three-layer structure, the lower MoNb layer is provided as an adhesion layer with respect to a foundation, and the upper MoNb layer is provided as a protection layer for protecting the AlNd layer.

The sealing member **25** is formed of a glass substrate, but is not limited thereto. For example, a plastic substrate can be used. Examples of the glass substrate include a soda-lime glass substrate and an alkali-free glass substrate. Examples of the plastic substrate include a polyethylene terephthalate (PET) substrate, a polyethylene naphthalate (PEN) substrate, a polyethersulfone (PES) substrate and a polycarbonate (PC) substrate. In case of using the plastic substrate,
it is preferred to form an SiON film, SiN film or the like on a surface of the plastic substrate to reduce moisture permeability. Material of the sealing member **25** preferably has a small difference in linear expansion coefficient with respect to material of the substrate **21,** and it is further preferable to have the same difference in linear expansion coefficient, in view of reducing stress caused of the difference in linear expansion coefficient between the sealing member **25** and the substrate **21.**

As described above, the sealing member **25** is bonded to the device substrate **23** through the joint member **24.** With this configuration, the sealing member **25** is cooperative with the device substrate **23** to hermitically encapsulate the organic EL device **22** therebetween. Note that, kinds of an interface **B** between the joint member **24** and the device substrate **23** include: a first interface **B1** between the joint member **24** and the first terminal **T1;** a second interface **B2** between the joint member **24** and the second terminal **T2;** and a third interface **B3** between the joint member **24** and the substrate **21.**

As a material of the joint member **24,** epoxy resin is used in the embodiment. Alternatively, acrylic resin or silicone resin can be used. Examples of the epoxy resin, acrylic resin and silicone resin include light curing (ultraviolet curing) adhesive, thermoset adhesive, two-part adhesive and the like. As a material of the joint member **24,** it is preferable to use an adhesive with inorganic fillers (e.g., made of silica or alumina). In a case where the joint member **24** is formed of the adhesive with inorganic fillers, it is possible to further suppress moisture permeation. The joint member **24** can be also formed of fritted material (such as fritted glass).

The light-emitting unit **2** is formed of the organic EL panel **20,** but is not limited thereto. The light-emitting unit **2** can be formed of an LED unit including light emitting diodes (LED). The LED unit preferably includes: the LEDs; a mounting substrate on which the LEDs are mounted; and a light distribution member configured to control a distribution of light from the LEDs, for example. Examples of the light distribution member include: an optical device such as a lens, a diffuser panel and a light reflector; and appropriate combinations thereof. The LED unit may be formed of the light panel **103** employed in the conventional portable illumination device described above. In the LED unit, the LEDs may be connected in series, connected in parallel, or connected in series-parallel combination.

In the light-emitting unit **2,** it is preferable to use the organic EL panel **20** rather than the LED unit. With this configuration, because the light-emitting unit **2** has a smaller amount of heat generation, it is possible to reduce a thickness and weight of the light-emitting device. In addition, it is possible to reduce a thickness of the light-emitting unit **2.** Furthermore, it is possible to generate a so-called subdued light (soft light) which relatively has a low directivity and is highly diffused.

The solar power generator **3** is formed of a sheet of solar panel **30.** The solar power generator **3** is not limited to one solar panel **30,** and may include solar panels **30** having small dimension and arranged in a plane, for example. Dimensions of the solar panels **30,** the number of the solar panel **30,** and the like can be appropriately determined in consideration of power generation efficiency, design and the like of the light-emitting device **1.** The solar panel **30** is formed of solar cells. Examples of the solar cell include a silicon-based solar cell, a compound-based solar cell and an organic solar cell. Examples of the silicon-based solar cell include a monocrystal silicon-based solar cell, a polycrystal silicon-based solar cell, a microcrystal silicon-based solar cell and a heterojunction solar cell. Examples of the compound-based solar cell include a group III-V compound multi-junction solar cell, a CIGS-based solar cell and a CdTe-based solar cell. Examples of the organic solar cell include a dye-sensitized solar cell and an organic semiconductor-based solar cell.

Examples of the rechargeable battery **4** include a lithium-ion battery and a nickel hydride battery. In the light-emitting device **1,** the rechargeable battery **4** is preferably arranged between the light-emitting unit **2** and the solar power generator **3** as described above, but the rechargeable battery **4** may be arranged in the exterior case **8** lateral to the light-electricity converter **A1.**

The lighting controller **29** is configured to be supplied with energy from the rechargeable battery **4** to power (light) the light-emitting unit **2.** The lighting controller **29** preferably has a color-adjusting function of changing color temperature and a dimming function of changing light amount of the light-emitting unit **2** by controlling a drive current of the light-emitting unit **2.** In other words, the lighting controller **29** is preferably formed of a lighting device which can control the light amount and the light color of the light-emitting unit **2.** The lighting device of the lighting controller **29** preferably includes a DC to DC converter, such as a chopper circuit, which is configured to convert an output voltage of the rechargeable battery 4 into a desired output voltage.

The charge controller **39** is preferably formed of a charging circuit configured to convert electric power generated in the solar power generator **3** into a desired voltage and current suited for charging the rechargeable battery **4** to charge the rechargeable battery **4.** The charge circuit of the charge controller **39** preferably has a function of preventing an overcharge of the rechargeable battery **4.**

The tilt switch **5** may be configured so that: the orientation sensor **51** includes a housing and a spherical body movable in the housing; and the state of the connection switch **52** in the form of the contact device of the change-over contact type switches according to a position of the spherical body in the housing. Thus, the orientation sensor **51** is configured to sense an orientation (inclination) of the light-electricity converter **A1** relative to vertical direction. Note that, "a state which the solar power generator 3 side in the light-electricity converter **A1** is upside" indicates a state where the light-receiving surface **302** of the solar power generator **3** faces toward a vertically upward direction.

The circuit board **7** is arranged between the non-light-emitting surface **201** of the light-emitting unit **2** and the non-light-receiving surface **301** of the solar power generator **3** so as to be apart from the light-emitting unit **2.** The circuit board **7** is formed of a rigid printed-wiring board. In the light-emitting device **1,** the rechargeable battery **4,** the tilt switch **5,** the lighting controller **29** and the charge controller **39** are mounted on one surface side of the circuit board **7** (on a first surface **701** side of the circuit board **7),** and the solar power generator **3** is mounted on the other surface side thereof (on a second surface **702** side of the circuit board **7).**

The exterior case **8** includes: a first cover **81;** and a second cover **82** coupled with the first cover **81.**

The first cover **81** is shaped like a thinned rectangular box, one surface of which is opened. An opening window **81b** for exposing therethrough the solar power generator **3** is formed in a bottom surface **81a** of the first cover **81.** The opening window **81b** is opened in a rectangular shape in the embodiment, but is not limited. Opening dimension of the opening window **81b,** the number of the opening windows **81b** and the like can be appropriately determined in consideration of the dimension and the number of the solar panels **30** constituting the solar power generator **3.** The first cover **81** is a synthetic resin molded article.

The second cover **82** is constituted by a first frame member **83** having a rectangular-frame shape and a second frame member **84** having a rectangular-frame shape, which are connected with each other. The first frame member **83** is a molded article of elastic synthetic resin (such as PBT and ABS). The second frame member **84** is a molded article of synthetic resin. The first frame member **81** and the second frame member **84** have the same external dimension with the second cover **81.** A thickness of the first frame member **81** is smaller than that of the second frame member **84.** The thickness of the second frame member **84** is larger than that in a peripheral region of the light-emitting unit **2.**

The first frame member **83** is provided with connection legs **83c** which are protruded from a surface of the first frame member **83** facing the second frame member 84. Each of the connection legs **83c** is provided with an engagement nail **83d** protruded from a tip of the connection leg **83c**, and is provided at an intermediate region in a width of the first frame member **83.** The second frame member **84** has a frame main body **84a** which is shaped like a rectangular frame having a smaller width than that of the first frame **83,** and engagement recesses **84d** which are formed at inner periphery of the frame main body **84a** and each of which is configured to be engaged with a corresponding engagement nail **83d** of the first frame member **83.** The second frame member **84** is provided with an inner flange **84c** protruded inward from the inner periphery of the frame main body **84a**.

The first frame member **83** and the second frame member **84** are connected with each other by engaging the engagement nails **83d** of the connection legs **83c** of the first frame member **83** with the respective engagement recesses **84d** formed in the inner periphery of the second frame member **84.** In the light-emitting device **1,** circumferential edge of the light-emitting unit **2** is clamped to be held between the first frame member **83** and the inner flange **84c** of the second frame member **84.** In the light-emitting device **1,** a first electrode plate **91** and a second electrode plate **92,** which are electrically connected to the first terminals **T1** and the second terminals **T2** of the organic EL panel **20** of the light-emitting unit **2,** respectively, are fixed to the inner flange **84c** of the second frame member **84.** The first electrode plate **91** is formed in a U-shape in a planar view, and has electrode pieces **91a** which respectively overlap with and are electrically connected with the first terminals **T1** of the organic EL panel **20.** The second electrode plate **92** is formed in a U-shape in a planar view, and has electrode pieces **92a** which respectively overlap with and are electrically connected with the second terminals **T2** of the organic EL panel **20.** The first electrode plate **91** and the second electrode plate **92** are designed so as not to be connected with each other in a thickness direction of the inner flange **84c** of the second frame member **84.**

Described in detail, the first electrode plate **91** and the second electrode plate **92** are preferably apart from each other by a predetermined interval in the thickness direction of the inner flange **84c** of the second frame member **84,** for example. The first electrode plate **91** and the second electrode plate **92** may be apart from each other by a predetermined interval, by fixing the first electrode plate **91** and the second electrode plate **92** with individual latch pieces which are formed on the inner flange **84c.** Alternatively, an insulation body may be provided between the first electrode plate **91** and the second electrode plate **92** so that the first electrode plate **91** and the second electrode plate **92** are apart from each other by a predetermined interval in the thickness direction of the inner flange **84c** of the second frame member **84.**

Each of the first electrode plate **91** and the second electrode plate **92** is electrically connected with the circuit board 7 through an electrical connector such as a lead wire (not shown). Thus, the light-emitting unit **2** is electrically connected with the lighting controller **39** on the first surface **701** of the circuit board **7.**

The light-emitting device **1** includes a heat insulating plate **6** (see FIG. 1) arranged at the one surface side of the circuit board **7** (the first surface **701** side of the board **7)** so as to face the circuit board **7.** In the light-emitting device **1,** the heat insulating plate **6** is arranged at the non-light-emitting surface **202** side of the light-emitting unit **2.** The heat insulating plate **6** is provided in order to thermally and electrically insulate the rechargeable battery **4** from the light-emitting unit **2.** Thus, the heat insulating plate **6** is preferably formed of resin having high heat insulation property and high electric insulation property. The heat insulating plate **6** is shaped like a rectangular plate. The heat insulating plate **6** may be formed integrally with the second frame member **84.**

It is preferred to provide column-shaped spacers **9** between the circuit board **7** and the heat insulating plate **6** for determining a distance therebetween. The spacer **9** is preferably formed of resin having high heat insulation property and high electric insulation property.

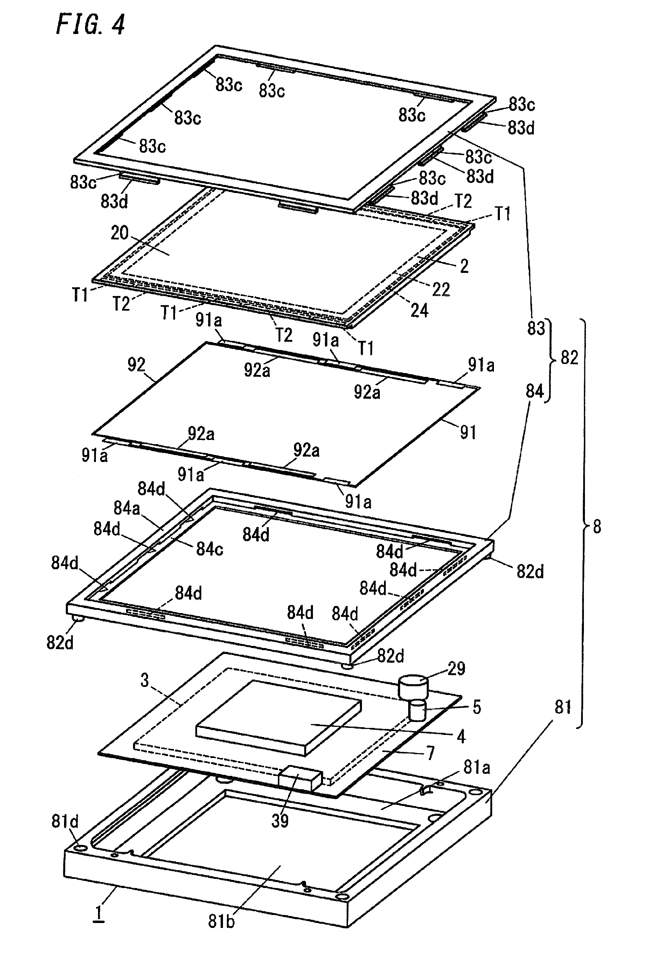

The second cover **82** is provided with columnar bosses **82d** (see FIG. 4) protruded from four corners of the second cover **82** (four corners of the second frame member **84,** in the embodiment), and the first cover **81** is provided with fitting holes **81d** (see FIG. 4) which are formed at four corners of a peripheral wall of the first cover **81** and into which the bosses **82d** are fitted. That is, the first cover **81** is preferably provided at corners of the peripheral wall thereof with fitting holes **81d** into which bosses **82d** protruded from corners of the second cover **82** (corners of the second frame member **84,** in the embodiment) are fitted. The first cover **81** is provided with screw insertion holes **81e** (see FIG. 1) communicated with the respective fitting holes **81d.** The first cover **81** and the second cover **82** are connected with each other by inserting screws (not shown) into the respective screw insertion holes **81e** of the first cover **81** and then screwing the screws with threaded holes **81e** formed in the bosses **82d.**

Circular screw covers **85** (see FIG. 1) are preferably provided in the respective screw insertion holes **81e** of the second cover **81** after connection of the first cover **81** and the second cover **82** in order to hide the screws. With this configuration, because the screws can be covered, the light-emitting device **1** can be prevented from being worsen cosmetically and can have an improved appearance. The screw cover **85** is fixed to the screw with a double-sided tape. Alternatively, the screw cover **85** may be fixed with a magnet.

The light-emitting device **1** is configured so that: when the orientation sensor **51** detects an orientation of the light-electricity converter **A1** that the side of the light-receiving surface **302** of the solar power generator **3** is upside, the rechargeable battery **4** is connected to the solar power generator **3** by the connection switch **52** as shown in FIG. 6(b); and when the orientation sensor **51** detects an orientation of the light-electricity converter **A1** that the side of the light-emitting surface **201** of the light-emitting unit **2** is upside, the rechargeable battery **4** is connected to the light-emitting unit **2** by the connection switch **52** as shown in FIG. 6(a). In a case where the solar power generator **3** is connected to the rechargeable battery **4** in the light-emitting device **1,** the solar power generator 3 is connected to the rechargeable battery **4** through the charge controller **39** and thereby the rechargeable battery **4** is charged with the electric power of the solar power generator **3.** In a case where the light-emitting unit **2** is connected to the rechargeable battery **4** in the light-emitting device **1,** the light-emitting unit **2** is connected to the rechargeable battery **4** through the lighting controller **29** and thereby the lighting controller **29** is powered from the rechargeable battery **4** to light the light-emitting unit **2.**

As described above, the light-emitting device 1 of the embodiment includes: the light-electricity converter **A1** composed of the light-emitting unit **2** shaped like a plane and the solar power generator **3** shaped like a plane which are arranged so that the rear surfaces of the light-emitting unit **2** and the solar power generator **3** face each other; and the rechargeable battery **4.** In other words, the light-emitting device **1** includes: the light-emitting unit **2** shaped like a plane having the light-emitting surface **201** and the non-light-emitting surface **202;** the solar power generator **3** shaped like a plane having the light-receiving surface **302** and the non-light-receiving surface **301;** and the rechargeable battery **4,** where the light-emitting unit **2** and the solar power generator **3** are arranged so that the non-light-emitting surface **202** of the light-emitting unit **2** and the non-light-receiving surface **301** of the solar power generator **3** face each other.

The light-emitting device **1** includes the orientation sensor 51 configured to sense the orientation of the light-electricity converter **A1,** and the connection switch **52** which is arranged between the light-emitting unit **2** and the solar power generator **3** and which is configured to selectively connect the rechargeable battery **4** to either the light-emitting unit **2** or the solar power generator **3.** The light-emitting device **1** is configured so that: when the orientation sensor **51** detects an orientation of the light-electricity converter **A1** that the side of the light-receiving surface **302** of the solar power generator **3** is upside (faces toward a first direction), the connection switch **52** connects the rechargeable battery **4** to the solar power generator **3**; and when the orientation sensor **51** detects an orientation of the light-electricity converter **A1** that the side of the light-emitting surface **201** of the light-emitting unit **2** is upside (faces toward the above mentioned first direction), the connection switch **52** connects the rechargeable battery **4** to the light-emitting unit **2.** Thus, the light-emitting device **1** of the embodiment is configured to automatically turning on and off the light-emitting unit **2** when the light-emitting device **1** is turned over by a user. Furthermore, the rechargeable battery unit **4** is configured to be charged by the solar power generator **3** when the light-emitting unit **2** is turned off. Consequently, in the light-emitting device **1** of the embodiment, because a state of the rechargeable battery **4** can be changed between a charging state and a discharging state when the light-emitting device **1** is turned over by a user, it is possible to eliminate a push-button and the like which the conventional device must include.

As a result, the light-emitting device **1** of the embodiment has an improved convenience and an improved appearance. The light-emitting device **1** can effectively use the energy, which is charged in the rechargeable battery unit **4** through the solar power generator **3** during daylight hours, for lighting the light-emitting unit **2** during nighttime or in a dark place. In addition, it is possible to prevent a charge loss caused by a discharge of the rechargeable battery **4** during charging of the rechargeable battery **4.**

In the light-emitting device **1** of the embodiment, because the connection switch **52** is formed of a tilt switch **5** that doubles as the orientation sensor **51,** it is possible to reduce the dimension occupied by the orientation sensor **51** and the connection switch **52.** In other words, because the orientation sensor **51** and the connection switch **52** form a single unit, the light-emitting device **1** of the embodiment has a reduced dimension occupied by the orientation sensor **51** and the connection switch **52.** In the embodiment, the tilt switch **5** which integrally includes the orientation sensor **51** and the connection switch **52** is used. Alternatively, the orientation sensor **51** may be formed of an acceleration sensor.

The light-emitting device **1** of the embodiment can be used in various situations and be applied to various utilization forms. For example, the light-emitting device **1** of the embodiment can be applied for the use of lighting in nighttime for a region (such as a developing country, a desert, and a mountain region) which is not built infrastructures sufficiently.

The light-emitting device **1** can be also used for lighting purpose in nighttime for a camp in seaside or mountain, or mountaineering. For this purpose, in order to charge the rechargeable battery **4** during daytime, it can be laid on a dashboard of a vehicle in a manner that the solar power generator **3** side is upside, be put in a basket of a bicycle in a manner that the solar power generator 3 side is upside, be suspended from a basket, or be clipped to a knapsack.

The light-emitting device **1** can be also applied for the use of lighting for each household in refugee camps or refuge facilities for victims of disasters.

The light-emitting device **1** can be also used as an alternative of an electric torch for doing some works (such as a restroom and finding something) during nighttime

The light-emitting device **1** can be also used for a game. For example, the light-emitting devices **1** can be used as disks of reversi (Othello (registered trademark)). For example, the light-emitting device **1** which the light-emitting unit **2** side is upside can be regarded as "white", and the light-emitting device **1** which the solar power generator **3** side is upside can be regarded as "black".

The light-emitting device **1** can be also used for creating atmosphere as a candle light in a cafe or a restaurant. Discharge duration of the rechargeable battery **4** depends on a capacity of the rechargeable battery **4,** and duration of lighting of the light-emitting unit **2** depends on the discharge duration, and accordingly the light-emitting device **1** can be used for notifying a termination of a reservation time.

The light-emitting device **1** can be also applied for the use of lighting for a garden party or barbecue in nighttime. The light-emitting device 1 can be used for lighting for a dark place such as a construction field where electricity infrastructure is not built, a work area for excavation work and a mine. For being used in such purpose, it is desirable to prepare another light-emitting device 1 as a backup.

### (Second Embodiment)

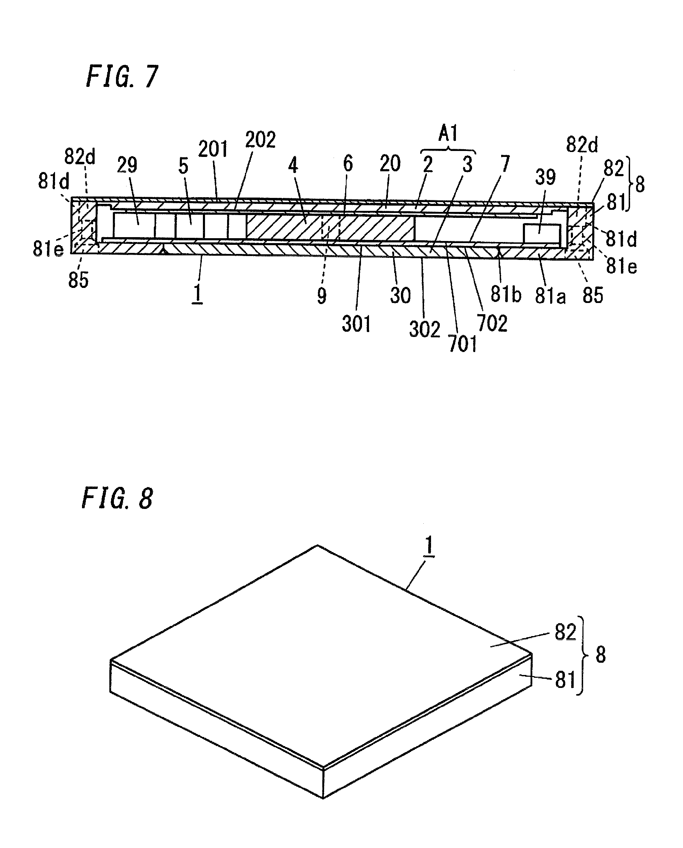

A light-emitting device according to the embodiment is described with reference to FIGS. 7 to 11.

The light-emitting device **1** of the embodiment includes a light-electricity converter **A1,** a rechargeable battery **4,** an orientation sensor **51,** and a connection switch **52.** The light-electricity converter **A1** is constituted by a light-emitting unit **2** shaped like a plane and a solar power generator **3** shaped like a plane. The light-emitting unit **2** and the solar power generator **3** are arranged so that rear surfaces of them face each other. The orientation sensor **51** is configured to sense an orientation of the light-electricity converter **A1.** The connection switch **52** is arranged between the light-emitting unit **2** and the solar power generator **3,** and is configured to selectively connect the rechargeable battery **4** to either the light-emitting unit **2** or the solar power generator **3.** The light-emitting device **1** is configured so that: the connection switch **52** connects the rechargeable battery 4 to the solar power generator **3** when the orientation sensor **51** detects an orientation of the light-electricity converter **A1** that the solar power generator **3** side is upside; and the connection switch **52** connects the rechargeable battery **4** to the light-emitting unit **2** when the orientation sensor **51** detects an orientation of the light-electricity converter **A1** that the light-emitting unit **2** side is upside.

The light-emitting device **1** of the embodiment has the substantially same basic configuration with the light-emitting device **1** of the first embodiment, and is different therefrom in shape of a second cover **82** of an exterior case **1.** Like kind elements are assigned the same reference numerals as depicted in the first embodiment, and are not explained in detail.

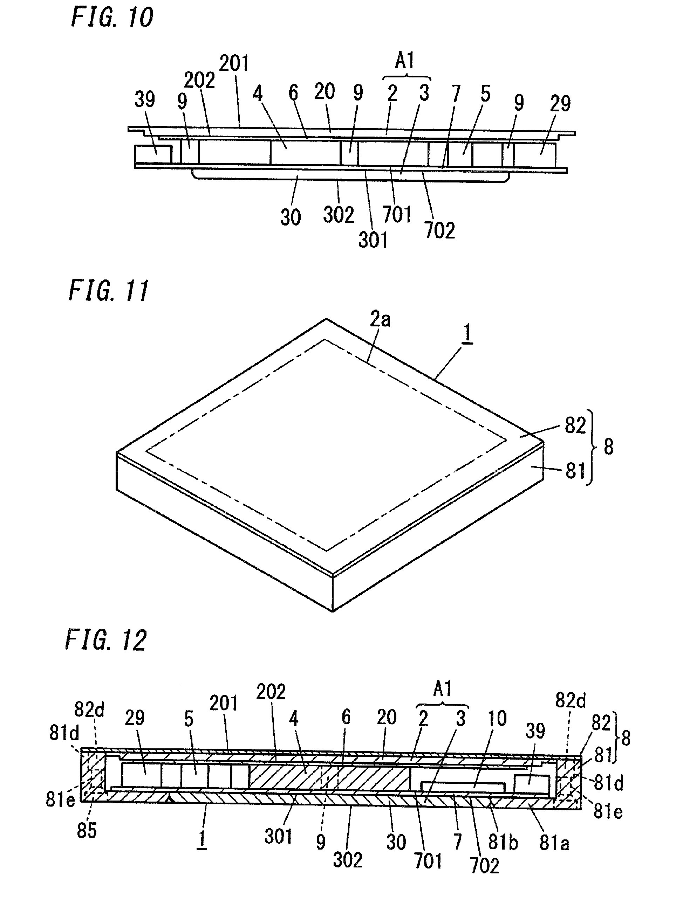

The second cover **82** of the light-emitting device **1** of the embodiment is shaped like a rectangular plate. The second cover **82** is an optically transparent synthetic resin molded article. The second cover **82** is preferably formed of semi-translucent synthetic resin. In this configuration, the light-emitting device 1 can provide subdued light by lighting the light-emitting unit **2.** The light-emitting device **1** can provide a user with a surprise, because a part of the second cover **82** which corresponds to a projection domain **2a** (see FIG. 11) of an organic EL device **22** in an organic EL panel **20** of the light-emitting unit **2** suddenly emits light when the light-emitting device **1** changes its state from a state in which the light-emitting unit **2** is turned off to a state in which the light-emitting unit **2** is turned on.

In the light-emitting device **1** of the embodiment, a first cover **81** and the second cover **82** are connected with each other by inserting screws (not shown) into respective screw insertion holes **81e** of the first cover **81** and then screwing the screws with threaded holes **81e** formed in bosses **82d,** as similar to the light-emitting device **1** of the first embodiment.

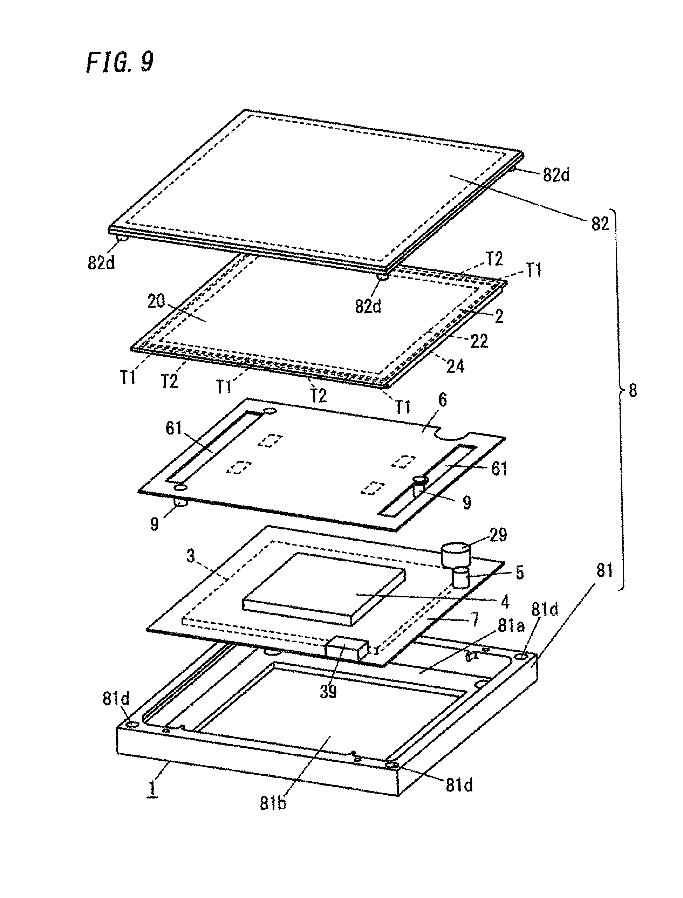

A heat insulating plate **6** is provided with openings **61** (see FIG. 9) through which respective electrical connectors such as lead wires (not shown) for electrically connecting the light-emitting unit **2** and a circuit board **7** are inserted. Alternatively, the light-emitting device 1 may include a flexible printed circuit board bonded to the light-emitting unit **2,** and the flexible circuit board is provided with patterned conductors which are electrically connected to a first terminal **T1** and a second terminal **T2** of the organic EL panel **20** of the light-emitting unit **2.** In this configuration, the circuit board **7** is preferably connected with the flexible printed circuit board through lead wires.

The light-emitting device **1** of the embodiment as described above has an improved convenience and an improved appearance, as similar to the first embodiment.

The second cover **82** is preferably formed of a rectangular plate, and the second cover **82** is preferably formed of semi-translucent synthetic resin. With this configuration, the light-emitting device **1** of the embodiment can exhibit a sense of unity and have an improved appearance, in comparison with the first embodiment.

The light-emitting device **1** of the embodiment can be easily designed to have waterproof property by providing such as an O-ring and sealing member to in position where should be waterproofed, and can be applied for the use of lighting for creating atmosphere in a bath, pool, aquarium, sea or the like.

### (Third Embodiment)

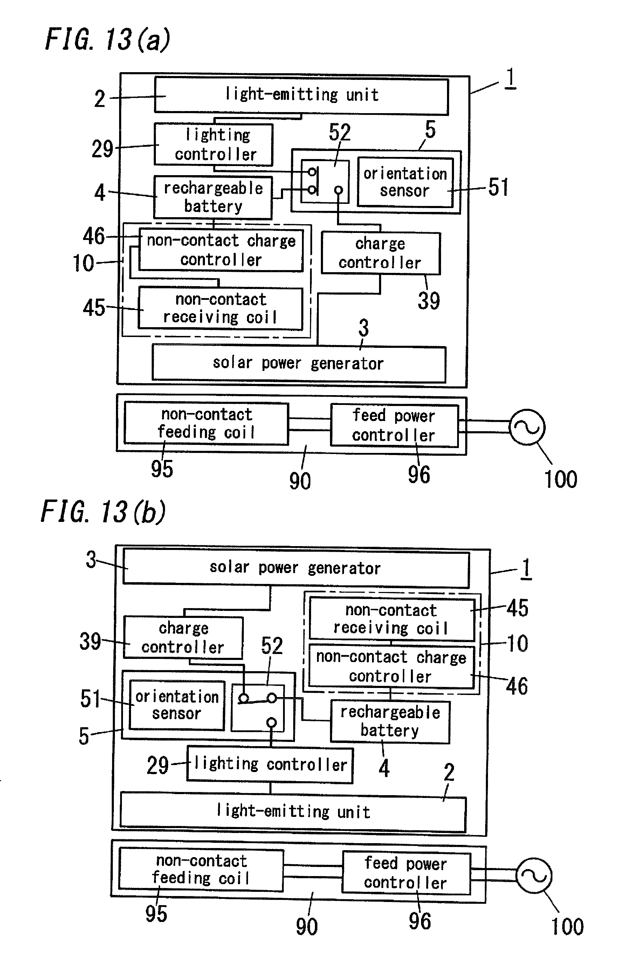

A light-emitting device according to the embodiment is described with reference to FIGS. 12 and 13.

The light-emitting device **1** of the embodiment includes a light-electricity converter **A1,** a rechargeable battery **4,** an orientation sensor **51,** and a connection switch 52. The light-electricity converter **A1** is constituted by a light-emitting unit **2** shaped like a plane and a solar power generator **3** shaped like a plane. The light-emitting unit **2** and the solar power generator **3** are arranged so that rear surfaces of them face each other. The orientation sensor **51** is configured to sense an orientation of the light-electricity converter **A1.** The connection switch **52** is arranged between the light-emitting unit **2** and the solar power generator **3,** and is configured to selectively connect the rechargeable battery **4** to either the light-emitting unit **2** or the solar power generator **3.** The light-emitting device **1** is configured so that: the connection switch **52** connects the rechargeable battery **4** to the solar power generator **3** when the orientation sensor **51** detects an orientation of the light-electricity converter **A1** that the solar power generator **3** side is upside; and the connection switch **52** connects the rechargeable battery **4** to the light-emitting unit **2** when the orientation sensor **51** detects an orientation of the light-electricity converter **A1** that the light-emitting unit **2** side is upside.

The light-emitting device **1** of the embodiment has the substantially same basic configuration with the light-emitting device **1** of the second embodiment, and is different therefrom in that a power receiving device **10** is further provided in an exterior case **8.** The power receiving device **10** is configured to convert, into an electric energy, a magnetic energy transmitted from a power feed device **90** (see FIG. 13) which is formed of a power feeding pad as a physically separated body from the light-emitting device **1.** Like kind elements are assigned the same reference numerals as depicted in the second embodiment, and are not explained in detail.

The power receiving device **10** is mounted on a first surface **701** of a circuit board **7.** In other words, the power receiving device **10** is mounted on a side of the circuit board **7** which is opposite to a side of a second surface **702** on which a solar power generator **3** is mounted.

The energy is preferably transmitted from the power feed device **90** to the power receiving device **10** through electromagnetic induction. In detail, a pair of couplers each of which is constituted by a magnetic body and a coil wound around the magnetic body can be used for this purpose. When the couplers are positioned so as to be magnetically coupled with each other, electric power can be transmitted from one of the couplers (a first coupler) to the other of the couplers (a second coupler). With this configuration, energy can be transmitted by applying current to a coil of a feeding-side coupler (the first coupler). In FIG. 13, a coil of the coupler (the first coupler) in the power feed device **10** is illustrated as a non-contact feeding coil **95,** and a coil of the coupler (the second coupler) in the power receiving device **10** is illustrated as a non-contact receiving coil **45.**

In the light-emitting device **1,** the size and structure of the power receiving device **10** is designed so that: the energy is transmitted from the power feed device **90** to the power receiving device **10** when the light-emitting device 1 is put on the power feed device **100** with the light-emitting unit **2** side up as shown in FIG, 13(a); and also the energy is not transmitted from the power feed device **90** to the power receiving device **10** when the light-emitting device **1** is put on the power feed device **90** with the solar power generator **3** side up as shown in FIG, 13(b).

The power feed device **90** includes a feed power controller **96** configured to be supplied with electric power from an AC source **100** and to regulate the current to be applied to the non-contact feeding coil **95.** The power receiving device **10** includes a non-contact charge controller **46** configured to charge the rechargeable battery **4** with the energy transmitted to the non-contact receiving coil **45** from the power feed device **90.**

With this configuration, the rechargeable battery **4** can be charged by putting the light-emitting device **1** of the embodiment on the power feed device **90** with the light-emitting unit **2** side up.

The non-contact charge controller **46** of the light-emitting device 1 of the embodiment is preferably configured to measure a charged state of the rechargeable battery **4,** and also to supply the non-contact feeding coil **95** side with a signal to start wireless power feeding before the rechargeable battery **4** discharges upto a charged amount which the light-emitting unit **2** cannot maintain its lighting. These configuration can resolve a problem of insufficient charged energy due to shortage in daylight and can lengthen a duration (duration of lighting) during which the light-emitting unit **2** can be lit.

The light-emitting device **1** of the embodiment as described above has an improved convenience and an improved appearance, as similar to the second embodiment.

In the example shown in FIG. 13, the power feed device **90** is connected to the AC source **100** (in detail, a power plug provided on one end of a power code of the power feed device **90** is connected to an outlet to which the electric power is supplied from the AC source such as a commercial AC source). Alternatively, the power feed device **90** may be supplied with the electric power through an AC adapter.

### (Fourth Embodiment)

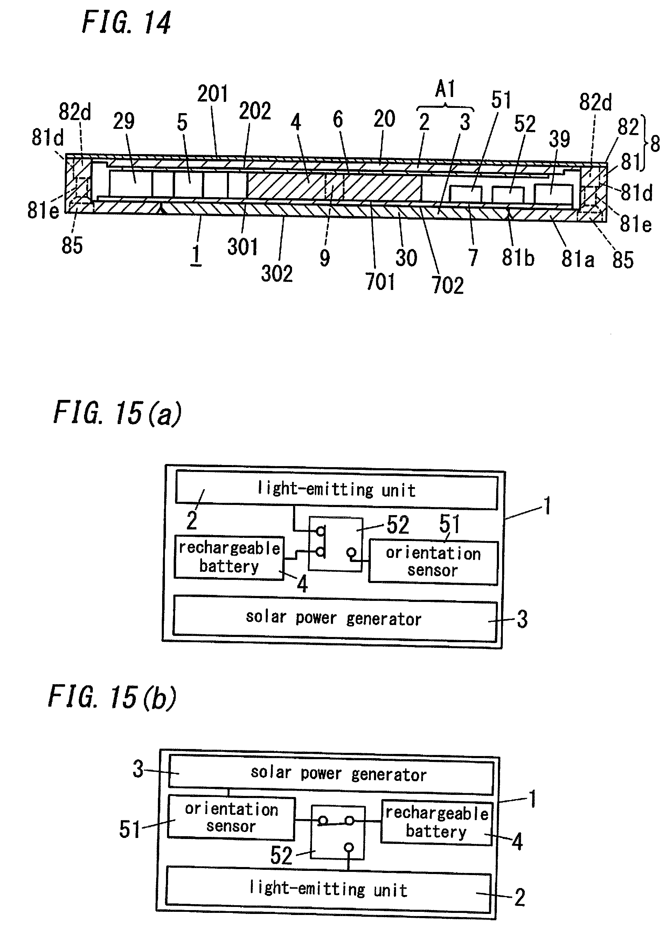

A light-emitting device according to the embodiment is described with reference to FIGS. 14 and 15.

The light-emitting device **1** of the embodiment includes a light-electricity converter **A1,** a rechargeable battery **4,** an orientation sensor **51,** and a connection switch **52.** The light-electricity converter **A1** is constituted by a light-emitting unit **2** shaped like a plane and a solar power generator **3** shaped like a plane. The light-emitting unit **2** and the solar power generator **3** are arranged so that rear surfaces of them face each other. The orientation sensor **51** is configured to sense an orientation of the light-electricity converter **A1.** The connection switch **52** is arranged between the light-emitting unit **2** and the solar power generator **3,** and is configured to selectively connect the rechargeable battery **4** to either the light-emitting unit **2** or the solar power generator **3.** The light-emitting device **1** is configured so that: the connection switch **52** connects the rechargeable battery **4** to the solar power generator **3** when the orientation sensor **51** detects an orientation of the light-electricity converter **A1** that the solar power generator **3** side is upside; and the connection switch **52** connects the rechargeable battery **4** to the light-emitting unit **2** when the orientation sensor **51** detects an orientation of the light-electricity converter **A1** that the light-emitting unit **2** side is upside.

The light-emitting device **1** of the embodiment has substantially the same basic configuration with the light-emitting device 1 of the first embodiment, and is different therefrom in that the orientation sensor **51** and the connection switch **52** are formed of separated bodies and are respectively mounted on one surface **701** of a circuit board **7.** Like kind elements are assigned the same reference numerals as depicted in the second embodiment, and are not explained in detail.

In the light-emitting device 1 of the embodiment, the connection switch **52** switches its state based on an output from the orientation sensor **51.** The orientation sensor **51** may be formed of a tilt sensor, an acceleration sensor, or the like. Detection principle of the tilt sensor, the acceleration sensor or the like is not limited particularly. In a configuration in which the orientation sensor **51** is formed of the tilt sensor or the acceleration sensor, the orientation sensor **51** can be arranged between the light-emitting unit **2** and the solar power generator **3.** The orientation sensor **51** may be an illumination sensor, an infrared sensor or the like. Such the sensor can sense an orientation of the light-electricity converter **A1** by arranging a light-receiving unit of the sensor in position. The connection switch 52 may be formed of other unit than a contact device of a change-over contact type, so long as capable of above switching operation.

The light-emitting device **1** of the embodiment as described above has an improved convenience and an improved appearance, as similar to the second embodiment.

## Claims

1. A light-emitting device comprises:
a light-emitting unit shaped like a plane having a light-emitting surface and a non-light-emitting surface;
a solar power generator shaped like a plane having a light-receiving part and a non-light-receiving part; and
a rechargeable battery, wherein
the light-emitting unit and the solar power generator are arranged so that the non-light-emitting surface and the non-light-receiving surface face each other, thereby forming a light-electricity converter,
the light-emitting device further comprises:
an orientation sensor configured to sense an orientation of the light-electricity converter; and
a connection switch which is arranged between the non-light-emitting surface of the light-emitting unit and the non-light-receiving surface of the solar power generator, and which is configured to selectively connect the rechargeable battery to either the light-emitting unit or the solar power generator,
the light-emitting device is configured so that: the connection switch connects the rechargeable battery to the solar power generator when the orientation sensor detects that the light-receiving surface of the solar power generator in the light-electricity converter faces toward a first direction; and the connection switch connects the rechargeable battery to the light-emitting unit when the orientation sensor detects that the light-emitting surface of the light-emitting unit in the light-electricity converter faces toward the first direction.

2. The light-emitting device according to claim 1, wherein the connection switch is formed of a tilt switch that doubles as the orientation sensor.

3. The light-emitting device according to claim 1 or 2, wherein the rechargeable battery is arranged between the light-emitting unit and the solar power generator.

4. The light-emitting device according to any one of claims 1 to 3, wherein the light-emitting unit includes an organic electroluminescent panel.
